(19) Europäisches Patentamt
European Patent Office
Office européen des brevets

(11) Publication number: **0 677 790 A1**

# (12) EUROPEAN PATENT APPLICATION

(21) Application number: **95200325.9**

(22) Date of filing: **10.02.95**

(51) Int. Cl.[6]: **G03F 7/07**, G03C 8/36, G03C 1/047

(30) Priority: **25.03.94 EP 94200793**

(43) Date of publication of application: **18.10.95 Bulletin 95/42**

(84) Designated Contracting States: **BE DE FR GB NL**

(71) Applicant: **AGFA-GEVAERT naamloze vennootschap**
**Septestraat 27**
**B-2640 Mortsel (BE)**

(72) Inventor: **De Keyzer, René, c/o Agfa-Gevaert N.V.**
**DIE 3800,**
**Septestraat 27**
**B-2640 Mortsel (BE)**
Inventor: **Van Rompuy, Ludo, c/o Agfa-Gevaert N.V.**
**DIE 3800,**
**Septestraat 27**
**B-2640 Mortsel (BE)**
Inventor: **Dewanckele, Jean-Marie, c/o Agfa-Gevaert N.V.**
**DIE 3800,**
**Septestraat 27**
**B-2640 Mortsel (BE)**
Inventor: **Monbaliu, Marcel, c/o Agfa-Gevaert N.V.**
**DIE 3800,**
**Septestraat 27**
**B-2640 Mortsel (BE)**

## (54) A method for making lithographic printing plates according to the silver salt diffusion transfer process.

(57) The present invention provides a method for making an offset printing plate according to the silver salt diffusion transfer process comprising the step of exposing an imaging element comprising in the order given on a hydrophilic surface of a support (i) an image receiving layer containing physical development nuclei and (ii) a photosensitive layer containing a silver halide emulsion and a low viscosity gelatin and developing it in the presence of a 1,2,4-triazolium-3-thiolate substituted with at least one substituent selected from the group consisting of a $C_1$-$C_8$ alkyl group that comprises at least 3 fluorine atoms, a $C_4$-$C_{10}$ hydrocarbon group and a 4-amino group substituted with a $C_1$-$C_8$ alkyl group that comprises at least 3 fluorine atoms and/or a $C_4$-$C_{10}$ hydrocarbon group.

EP 0 677 790 A1

1. Field of the invention.

The present invention relates to a method for making improved lithographic printing plates according to the silver salt diffusion transfer process.

2. Background of the invention.

The principles of the silver complex diffusion transfer reversal process, hereinafter called DTR-process, have been described e.g. in US-P-2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellent ink-receptive areas on a water-receptive ink-repellent background.

The DTR-image can be formed in the image receiving layer of a sheet or web material which is a separate element with respect to the photographic silver halide emulsion material (a so-called two-sheet DTR element) or in the image receiving layer of a so-called single-support-element, also called mono-sheet element, which contains at least one photographic silver halide emulsion layer integral with an image receiving layer in waterpermeable relationship therewith. It is the latter mono-sheet version which is preferred for the preparation of offset printing plates by the DTR method.

Two types of the mono-sheet DTR offset printing plate exist. According to a first type disclosed in e.g. US-P-4,722,535 and GB-1,241,661 a support is provided in the order given with a silver halide emulsion layer and a layer containing physical development nuclei serving as the image-receiving layer. After information-wise exposure and development the imaged element is used as a printing plate without the removal of the emulsion layer.

According to a second type of mono-sheet DTR offset printing plate a hydrophilic support, mostly anodised aluminium, is provided in the order given with a layer of physical development nuclei and a silver halide emulsion layer. After information-wise exposure and development the imaged element is treated to remove the emulsion layer so that a support carrying a silver image is left wich is used as a printing plate. Such type of lithographic printing plate is disclosed e.g. in US-P-3,511,656.

As for other printing plates it is required that the offset printing plates belonging to the second type of mono-sheet DTR offset printing plates have good printing properties: a high contrast, a high printing endurance, good ink acceptance in the printing areas, no ink acceptance in the non-printing areas (no staining) and furthermore a low number of copies that have to be disposed off because of ink acceptance in the non-printing areas (so called toning) during start-up of the printing process.

1,2,4-Triazolium-3-thiolates are disclosed as silver halide solvents suitable for use in a method for making a lithographic printing plate of the first type according to the silver salt diffusion transfer process in e.g. EP-A 535,678, 554, 585 and JP Pi 04/324478. 1,2,4-Triazolium-3-thiolates are disclosed as silver halide solvents suitable for use in a method for making a lithographic printing plate of the second type according to the silver salt diffusion transfer process in EP-A 554,585.

In EP-A 93202310.4 the use of a low viscosity gelatin in the emulsion layer of an imaging element suitable for use in a method for making a mono-sheet DTR offset printing plates of the second type in order to improve the printing properties of such a plate is disclosed. 1,2,4-Triazolium-3-thiolates are mentioned as suitable silver halide solvents. However, when using these compounds as silver halide solvents in a method for making a lithographic printing plate from the above mentioned imaging element, the results are not satisfactory.

3. Summary of the invention.

It is an object of the present invention to provide a method for making offset printing plates according to the DTR-process having good printing properties i.a. a high contrast, good ink acceptance in the printing areas, no ink acceptance in the non-printing areas, good reproduction characteristics and a high printing endurance.

Further objects of the present invention will become clear from the description hereinafter.

According to the present invention there is provided a method for making an offset printing plate according to the silver salt diffusion transfer process comprising the steps of:

- image-wise exposing an imaging element comprising in the order given on a hydrophilic surface of a support (i) an image receiving layer containing physical development nuclei and (ii) a photosensitive layer containing a silver halide emulsion and gelatin whereof a 10 % by weight aqueous solution at 36 °C and pH 6 has a viscosity lower than 20 mPa.s at a shearing rate of 1000 $s^{-1}$, said photosensitive layer being in water permeable relationship with said image receiving layer,
- applying an aqueous alkaline solution to the imaging element in the the presence of (i) (a) developing agent(s), (ii) a 1,2,4-triazolium-3-thiolate and (iii) (a) further silver halide solvent(s) to form a silver image in said image receiving layer,
- treating the imaging element to remove the layer(s) on top of the image receiving layer, thereby uncovering said silver image formed in said image receiving layer,

characterized in that said 1,2,4-triazolium-3-thiolate is substituted with at least one substituent selected from the group consisting of a $C_1$-$C_8$ alkyl group that comprises at least 3 fluorine atoms, a $C_4$-$C_{10}$ hydrocarbon group and a 4-amino group substituted with a $C_1$-$C_8$ alkyl group that comprises at least 3 fluorine atoms and/or a $C_4$-$C_{10}$ hydrocarbon group.

According to the present invention there is also provided an imaging element and an alkaline processing liquid for use in the above defined method.

4. Detailed description of the invention.

It has been found that a lithographic printing plate prepared from an imaging element comprising a low viscosity gelatin in the silver halide emulsion layer according to the DTR-process in the presence of a 1,2,4-triazolium-3-thiolate as defined above and (a) further silver halide solvent(s) has an increased printing endurance, good ink acceptance at the start of the printing process, good reproduction characteristics and a high printing contrast.

The problem that 1,2,4-triazolium-3-thiolates suitable for use in a method for making a lithographic printing plate of the first type are not suitable for making a lithographic printing plate of the second type from the above mentioned imaging element was not disclosed until now and consequently no solution for this problem was suggested.

Said $C_1$-$C_8$ alkyl group that comprises at least 3 fluorine atoms can be further substituted by fluorine atoms or other substituents if it is not a $CF_3$-group. Preferably said $C_1$-$C_8$ alkyl group comprises at least one $CF_3$-group and/or at least two $-CF_2$-groups.

Said $C_4$-$C_{10}$ hydrocarbon group includes unsubstituted or substituted $C_4$-$C_{10}$ alkyl groups, unsubstituted or substituted $c_5$-$c_{10}$ cycloalkyl groups, each of which may contain one or more divalent linking group such as -O-, -S-, -CH=CH-, -C=C- etc., unsubstituted or substituted $C_7$-$C_{10}$ aralkyl groups, unsubstituted or substituted $C_6$-$C_{10}$ aryl groups and unsubstituted or substituted $C_4$-$C_{10}$ heterocyclic groups.

The synthesis of the above defined 1,2,4-triazolium-3-thiolates suited for use in the present invention is well known and has been described in e.g. **Journal of Heterocyclic Chemistry**, 2, 105(1965), **Journal of Organic Chemistry**, 32, 2245(1967), **Journal of The Chemical Society**, 3799(1969) and **Journal of The American Chemical Society**, 80, 1895(1958).

The 1,2,4-triazolium-3-thiolates in accordance with the present invention are preferably substituted with at least one substituent selected from the group consisting of a $C_1$-$C_5$ alkyl group that comprises at least one $CF_3$-group and/or at least two $-CF_2$-groups, a $C_4$-$C_8$ hydrocarbon group or a 4-amino group substituted with a $C_1$-$C_5$ alkyl group that comprises at least one $CF_3$-group and/or at least two $-CF_2$-groups or a $C_4$-$C_8$ hydrocarbon group and have a total number of carbon atoms less than 18.

More preferred 1,2,4-triazolium-3-thiolates for use according to the present invention corresponds to one of the following two formulas I or II:

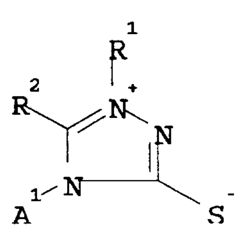

(I)

wherein $R^1$ represents a $C_1$-$C_5$ alkyl group that comprises at least one $CF_3$-group and/or at least two $-CF_2$-groups, $R^2$ represents an unsubstituted or substituted alkyl group, alkenyl group, alkynyl group, cycloalkyl group, aralkyl group, aryl group or heterocyclic group, $A^1$ represents an unsubstituted or substituted alkyl group, alkenyl group, alkynyl group, cycloalkyl group, aralkyl group, aryl group, heterocyclic group or $-NR^3R^4$ and $R^3$ and $R^4$ each independently represents hydrogen or an unsubstituted or substituted alkyl group or aryl group or $R^3$ and $R^4$ can combine with each other to form a 5-or 6-membered ring and wherein the total number of carbon atoms is less than 14;

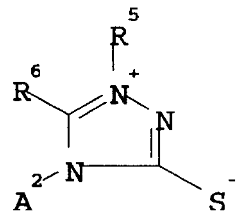

(II)

wherein $R^5$ and $R^6$ each independently represents an unsubstituted or substituted alkyl group, alkenyl group, alkynyl group, cycloalkyl group, aralkyl group, aryl group or heterocyclic group, $A^2$ represents an unsubstituted or substituted alkyl group, alkenyl group, alkynyl group, cycloalkyl group, aralkyl group, aryl group, heterocyclic group or $-NR^7R^8$, $R^7$ and $R^8$ each independently represents hydrogen or an unsubstituted or substituted alkyl group or aryl group, wherein at least one of the substituents $R^5$, $R^6$, $R^7$ or $R^8$ is an unsubstituted or substituted $C_4$-$C_8$ hydrocarbon group and wherein the total number of carbon atoms is less than 14.

Even more preferably, said 1,2,4-triazolium-3-thiolates corresponds either to formula I wherein $R^1$ represents a $C_1$-$C_5$ alkyl group that comprises at least one $CF_3$-group and/or at least two $-CF_2$-groups and $R^2$ and $A^1$ each independently represents an unsubstituted or substituted $C_1$-$C_4$ alkyl group, alkenyl group or alkynyl group; or to formula II wherein $R^5$ and $R^6$ or $R^5$ and $A^2$ or $R^6$ and $A^2$ each independently represents an unsubstituted or substituted $C_1$-$C_4$ alkyl group, alkenyl group or alkynyl group, the third substituent represents an unsubstituted or substituted $C_4$-$C_8$ alkyl group, $C_4$-$C_8$ alkenyl group, $C_4$-$C_8$ alkynyl group, $C_5$-$C_8$ cycloalkyl group and wherein the total number of carbon atoms is less than 14.

Particularly preferably, said 1,2,4-triazolium-3-thiolates corresponds either to formula I wherein $R^1$ represents a $C_1$-$C_5$ alkyl group that contains at least 3 fluorine atoms and which may be further substituted and $R^2$ and $A^1$ each independently represents an unsubstituted or substituted methyl or ethyl group; or to formula II wherein $R^5$ and $R^6$ or $R^5$ and $A^2$ or $R^6$ and $A^2$ each independently represents an unsubstituted or substituted methyl or ethyl group and the third substituent represents an unsubstituted or substituted $C_4$-$C_8$ alkyl group, $C_4$-$C_8$ alkenyl group, $C_4$-$C_8$ alkynyl group or $C_5$-$C_8$ cycloalkyl group.

Most preferably, said 1,2,4-triazolium-3-thiolates corresponds either to formula I wherein $R^1$ represents a $CF_3CH_2$- group and $R^2$ and $A^1$ each independently represents an unsubstituted or substituted methyl or ethyl group; or to formula II wherein $R^5$ and $R^6$ or $R^5$ and $A^2$ or $R^6$ and $A^2$ each independently represents an unsubstituted or substituted methyl or ethyl group and the third substituent represents an unsubstituted or substituted $C_4$-$C_8$ alkyl group or $C_4$-$C_8$ alkenyl group.

Specific examples of 1,2,4-triazolium-3-thiolates suitable for use in accordance with the present invention are shown in table 1.

Table 1

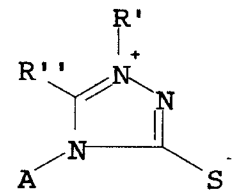

| Compound No. | R' | R'' | A |
|---|---|---|---|
| 1 | $CF_3CHFCF_2CH_2$- | $CH_3$- | $CH_3$- |
| 2 | $H(CF_2)_4CH_2$- | $CH_3$- | $CH_3$- |
| 3 | $CF_3CH_2$- | $CH_3$- | $CH_3$- |
| 4 | $CF_3CH_2$- | $CH_3$- | $CH_2 = CHCH_2$- |
| 5 | $CH_3$- | n-$C_5H_{11}$- | $CH_3$- |
| 6 | $CH_3$- | $C_2H_5CH = CHCH_2$- | $(CH_3)_2N$- |
| 7 | $CH_3$- | $CH_3$- | $CH_2 = CH(CH_2)_2$- |
| 8 | $CH_3$- | $CH_3$- | n-$C_6H_{13}$- |
| 9 | $C_6H_5$- | $CH_3$- | $CH_3$- |
| 10 | $CH_3$- | $CH_3$- | n-$C_6H_{13}NH$- |

According to the present invention the 1,2,4-triazolium-3-thiolate is incorporated in the alkaline liquid preferably in an amount between 0.1 mmol/l and 25 mmol/l, more preferably between 0.5 mmol/l and 10 mmol/l and most preferably between 2 mmol/l and 8 mmol/l and/or in the imaging element in an amount preferably between 0.1 and 10 mmol/m$^2$, more preferably between 0.1 and 5 mmol/m$^2$ and most preferably between 0.5 and 1.5 mmol/m$^2$. .

According to the preferred embodiment of the present invention at least part and most preferably all of the 1,2,4-triazolium-3-thiolate is present in the alkaline processing liquid used by developing the image-wise exposed imaging element. However the 1,2,4-triazolium-3-thiolate may be incorporated in one or more layers comprised on the support of the imaging element. This offers the advantage of replenishment of said 1,2,4-triazolium-3-thiolate in the alkaline processing liquid. Preferably the 1,2,4-triazolium-3-thiolate is incorporated in a layer of the imaging element that does not contain silver halide such as e.g. in a backing layer, in the image receiving layer, a subbing layer etc..

According to the present invention the development and diffusion transfer of the information-wise exposed imaging element in order to form a silver image in said photosensitive layer and to allow unreduced silver halide or complexes formed thereof to diffuse image-wise from the photosensitive layer to said image receiving layer to produce therein a silver image, are effected with the aid of an aqueous alkaline solution in the presence of (a) developing agent(s) and (a) further silver halide solvent(s). The developing agent(s) and/or the silver halide solvent(s) can be incorporated in the aqueous alkaline solution and/or in the imaging element.

Preferably the alkaline processing liquid used for developing the imaging element contains a further silver halide solvent. Preferably a further silver halide solvent is used in an amount between 0.05% by weight and 5% by weight and more preferably between 0.5% by weight and 2% by weight. Suitable further silver halide solvents for use in connection with the present invention are thiocyanates and thiosulfates. Other further silver halide solvents that can be used in connection with the present invention are e.g. sulphite, amines, 2-mercaptobenzoic acid, cyclic imide compounds such as e.g. uracil and 5,5-dialkylhydantoins, alkyl sulfones and oxazolidones.

Preferred silver halide solvents for use in connection with the present invention are alkanolamines. Examples of alkanolamines that may be used in connection with the present invention correspond to the following formula:

$C_1H_{21}$-X
N-$C_mH_{2m}$-X'
$C_nH_{2n}$-OH

wherein X and X' independently represent hydrogen, a hydroxyl group or an amino group, 1 and m represent 0 or integers of 1 or more and n represents an integer of 1 or more. Preferably used alkanolamines are e.g. diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol etc. or mixtures thereof. A particularly preferred alkanolamine for use in connection with the present invention is N-(2-aminoethyl)ethanolamine.

According to the present invention the alkanolamines are preferably present in the alkaline processing liquid in a concentration preferably between 0.1% and 5% by weight. However part or all of the alkanolamine can be present in one or more layers of the imaging element.

Still other preferred further silver halide solvents for use in connection with the present invention are thioethers. Preferably used thioethers correspond to the following general formula:

Z-$(R^9$-S$)_t$-$R^{10}$-S-$R^{11}$-Y

wherein Z and Y each independently represents hydrogen, an alkyl group, an amino group, an ammonium group, a hydroxyl, a sulfo group, a carboxyl, an aminocarbonyl or an aminosulfonyl, $R^9$, $R^{10}$ and $R^{11}$ each independently represents an alkylene that may be substituted and optionally contain a oxygen bridge and t represents an integer from 0 to 10. Examples of thioether compounds corresponding to the above formula are disclosed in e.g. US-P-4.960.683 and EP-A 554,585.

Combinations of different further silver halide solvents can be used and it is also possible to incorporate at least one further silver halide solvent into a suitable layer of the imaging element and to add at least one other further silver halide solvent to the developing solution.

The aqueous alkaline solution in accordance with the present invention may further comprise sulphite e.g. sodium sulphite in an amount ranging from 40 g to 180 g per liter, preferably from 60 to 160 g per liter in combination with another silver halide solvent.

The alkaline processing liquid may also contain the developing agent(s) used in accordance with the present invention. In this case the alkaline processing liquid is called a developer. On the other hand some or all of the developing agent(s) may be present in one or more layers of the imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used. Preferred amounts of the hydroquinone-type developing agents are in the range of 0.05 mole to 0.25 mole per litre and preferred amounts of secondary developing agent(s) in the range of $1.8 \times 10^{-3}$ to $2.0 \times 10^{-2}$ mole per litre.

The quantitative ranges given for the developing agents, silver halide solvents, and sulphite apply to the amount of these compounds present as solutes in the aqueous alkaline solution during the DTR-processing, whether these compounds make part of the aqueous alkaline solution or were dissolved from the layers containing them upon application thereto of the aqueous alkaline solution.

The aqueous alkaline solution suitable for use according to the present invention preferably comprises aluminium ions in an amount of at least 0.3 g/l, more preferably in an amount of at least 0.6 g/l in order to prevent sticking of the emulsion layer to the transporting rollers when the emulsion is swollen with the aqueous alkaline solution.

The alkaline processing liquid preferably has a pH between 9 and 14 and more preferably between 10 and 13, but depends on the type of silver halide emulsion material to be developed, intended development time, and processing temperature.

The processing conditions such as temperature and time may vary within broad ranges provided the mechanical strength of the materials to be processed is not adversely influenced and no decomposition takes place.

The pH of the alkaline processing liquid may be established by an organic or inorganic alkaline substance or a combination thereof. Suitable inorganic alkaline substances are e.g. hydroxides of sodium and potassium, alkali metal salts of phosphoric acid and/or silicic acid e.g. trisodium phosphate, orthosilicates, metasilicates, hydrodisilicates of sodium or potassium, and sodium carbonate etc. . Suitable organic alkaline substances are e.g. alkanolamines. In the latter case the alkanolamines will provide or help providing the pH and serve as a silver halide complexing agent.

The aqueous alkaline solution may further comprise hydrophobizing agents for improving the hydrophobicity of the silver image obtained in the image image receiving layer. Generally these compounds contain a mercapto group or thiolate group and one or more hydrophobic substituents. Particularly preferred hydrophobizing agents are mercapto-1,3,4-thiadiazoles as described in DE-A 1,228,927 and in US-P 4,563,410, 2-mercapto-5-heptyloxa-3,4-diazole and long chain (at least 5 carbon atoms) alkyl substituted mercaptotetrazoles. The hydrophobizing agents can be used alone or in combination with each other.

These hydrophobizing compounds can be added to the aqueous alkaline solution in an amount of preferably 0.1 to 3 g per litre and preferably in admixture with 1-phenyl-5-mercaptotetrazole, the latter compound may be used in amounts of e.g. 50 mg to 1.2 g per litre of solution, which may contain a minor amount of ethanol to improve the dissolution of said compounds.

The aqueous alkaline solution may comprise other ingredients such as e.g. oxidation preservatives, a compound releasing bromide ions, calcium-sequestering compounds, anti-sludge agents, and hardeners including latent hardeners.

Regeneration of the aqueous alkaline solution according to known methods is, of course, possible, whether the solution incorporates developing agent(s) and/or silver halide solvent(s) or not.

The development may be stopped - though this is often not necessary - with a so-called stabilization liquid, which actually is an acidic stop-bath having a pH preferably in the range of 5 to 6.

Bufferred stop bath compositions comprising a mixture of sodium dihydrogen orthophosphate and disodium hydrogen orthophosphate and having a pH in said range are preferred.

The development and diffusion transfer can be initiated in different ways e.g. by rubbing with a roller, by wiping with an absorbent means e.g. with a plug of cotton or sponge, or by dipping the material to be treated in the liquid composition. Preferably, they proceed in an automatically operated apparatus. They are normally carried out at a temperature in the range of 18 °C to 30 °C.

After formation of the silver image on the hydrophilic base an excess of alkaline solution still present on the base may be eliminated, preferably by guiding the foil through a pair of squeezing rollers.

The silver image thus obtained in the layer of physical development nuclei is subsequently uncovered by treating the imaging element to remove all the layers above the layer containing physical development nuclei.

According to a particularly preferred embodiment of the present invention the silver image in the layer of physical development nuclei is exposed by washing off all the layers above the layer containing physical development nuclei with rinsing water.

The temperature of the rinsing water may be varied widely but is preferably between 20 °C and 45 °C.

The imaged surface of the lithographic base can be subjected to a chemical treatment that increases the hydrophilicity of the non-silver image parts and the oleophilicity of the silver image.

This chemical after-treatment is preferably carried out with a lithographic composition often called fixer, which comprises at least one compound enhancing the ink-receptivity and/or lacquer-receptivity of the silver image, and also comprises at least one compound that improves the ink-repelling characteristics of the hydrophilic base.

Suitable ingredients for the fixer are e.g. organic compounds containing a mercapto group such as the hydrophobizing compounds referred to hereinbefore for the alkaline solution and compounds corresponding to one of the following formulas:

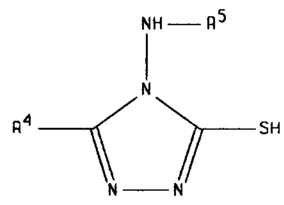

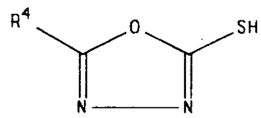

wherein $R^6$ represents hydrogen or an acyl group, $R^5$ represents alkyl, aryl or aralkyl.

A suitable fixer as disclosed in US-A-4.563.410 is a composition comprising a solution of a mercaptotriazole in a solution of polyethylene oxide with a molecular weight of 4,000. Further suitable fixers have been described in i.a. US-A 4.062.682.

At the moment the treatment with the fixer is started the surface carrying the silver pattern may be in dry or wet state. In general, the treatment with the fixer does not take long, usually not longer than about 30 seconds and it may be carried out immediately after the processing and uncovering steps.

The fixer can be applied in different ways such as by rubbing with a roller, by wiping with an absorbent means e.g. with a plug of cotton or sponge, or by dipping the material to be treated in the fixer. The image-hydrophobizing step of the printing plate may also proceed automatically by conducting the printing plate through a device having a narrow channel filled with the fixer and conveying the printing plate at the end of the channel between two squeezing rollers removing the excess of liquid.

As soon as the hydrophilic base carrying the silver image has been treated with the fixer, it is ready to be used as a printing plate.

According to the present invention the imaging element can be information-wise exposed in an apparatus according to its particular application. A wide choice of cameras for exposing the photosensitive silver halide emulsion exists on the market. Horizontal, vertical and darkroom type cameras and contact-exposure apparatus are available to suit any particular class of reprographic work. The imaging element in accordance with the present invention can also be exposed with the aid of i.a. laser recorders and cathode rays tubes.

The imaging element for use in the present invention for making an offset printing plate essentially comprises in the order given (i) a hydrophilic base, (ii) an image receiving layer containing physical development nuclei and (iii) a photosensitive layer containing a silver halide emulsion and a low viscosity gelatin said photosensitive layer being in water permeable relationship with said image receiving layer.

The imaging element is preferably prepared by coating the different layers on a hydrophilic layer of a support. Alternatively the different layers may be laminated to said image receiving layer from a temporary base holding the layers in reverse order as disclosed in US-P 5,068,165.

The hydrophilic layer of a support can be a hardened hydrophilic layer, containing a hydrophilic synthetic homopolymer or copolymer and being hardened with a hydrolyzed tetraalkyl orthosilicate crosslinking agent coated on a flexible hydrophobic base. More preferably the hydrophilic layer is part of an aluminium support.

The aluminium support of the imaging element used according to the present invention can be made of pure aluminium or of an aluminium alloy, the aluminium content of which is at least 95%. The thickness of the support usually ranges from about 0.13 to about 0.50 mm.

The preparation of aluminium or aluminium alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results.

Graining of the aluminium surface can be carried out mechanically or electrolytically in any known way. The roughness produced by the graining is measured as a centre line average value expressed in $\mu$m and preferably varies from about 0.2 to about 1.5 $\mu$m.

The anodization of the aluminium foil can be performed in electrolytes such as e.g. chromic acid, oxalic acid, sodium carbonate, sodium hydroxide, and mixtures thereof. Preferably, the anodization of the aluminium is performed in dilute aqueous sulphuric acid medium until the desired thickness of the anodization layer is reached. The aluminium foil may be anodized on both sides. The thickness of the anodization layer is most accurately measured by making a micrographic cut but can be determined likewise by dissolving the anodized layer and weighing the plate before dissolution treatment and subsequent thereto. Good results are obtained with an anodization layer thickness of about 0.4 to about 2.00 µm.

After the anodizing step the anodic surface may be sealed. Sealing of the pores of the aluminium oxide layer formed by anodization is a technique known to those skilled in the art of aluminium anodization. The anodic surface of the aluminium foil can thus be rinsed with water at 70-100 °C or with steam. The sealing can also be performed by treatment of the anodic surface with an aqueous solution comprising phosphate ions or silicates. Preferably the sealing is performed by means of an aqueous solution containing a bicarbonate as disclosed in EP-A 567,178. Thanks to the sealing treatment the anodic layer is rendered substantially non-porous so that longer press runs can be made with the printing plate obtained. As a result of the sealing the occurrence of fog in the non-printing areas of the printing plate is avoided substantially.

The graining, anodizing, and sealing of the aluminium foil can be performed as described in e.g. US-A-3,861,917 and in the documents referred to therein.

To promote the image sharpness and, as a consequence thereof, the sharpness of the final printed copy, the anodization layer may be coloured in the mass with an antihalation dye or pigment e.g. as described in JA-Pu-58-14,797.

Subsequent to the preparation of the hydrophilic layer of a support as described above the hydrophilic layer of a support may be immediately coated with a solution containing the physical development nuclei or may be coated with said solution at a later stage.

The image receiving layer for use in accordance with the present invention is preferably free of hydrophilic binder but may comprise small amounts up to 80% by weight of the total weight of said layer of a hydrophilic colloid e.g. polyvinyl alcohol to improve the hydrophilicity of the layer.

Preferred development nuclei for use in accordance with the present invention are sulphides of heavy metals e.g. sulphides of antimony, bismuth, cadmium, cobalt, lead, nickel, palladium, platinum, silver, and zinc. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form. More preferred development nuclei for use in accordance with the present invention are nuclei, especially sulphides of heavy metals having an average diameter less than 6 nm and wherein the number of nuclei having a diameter larger than 4.5 nm is less than 15% of the total number of nuclei contained in said image receiving layer as disclosed in EP-A 546,598. Especially preferred development nuclei in connection with the present invention are palladium sulphide nuclei having an average diameter less than 6 nm and wherein the number of nuclei having a diameter larger than 4.5 nm is less than 15% of the total number of nuclei contained in said image receiving layer.

To promote the image sharpness the hydrophilic layer of a support can be provided with a very thin antihalation coating of a dye or pigment or the image receiving layer may incorporate at least one antihalation dye or pigment.

The photosensitive layer used in accordance with the present invention may be any layer comprising a hydrophilic colloid binder and at least one photosensitive silver halide emulsion, being in water permeable relationship with said image receiving layer.

Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or the complexed silver.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

For use according to the present invention the silver halide emulsion or emulsions preferably consist principally of silver chloride while a fraction of silver bromide may be present ranging from 1 mole % to 40 mole %. Most preferably a silver halide emulsion containing at least 70 mole% of silver chloride is used.

The average size of the silver halide grains may range from 0.10 to 0.70 µm , preferably from 0.25 to 0.45 µm.

Preferably during the precipitation stage iridium and/or rhodium containing compounds or a mixture of both are added. The concentration of these added compounds ranges from $10^{-8}$ to $10^{-3}$ mole per mole of $AgNO_3$, preferably between $10^{-7}$ and $10^{-6}$ mole per mole of $AgNO_3$.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-A-493,464 and 568,687, and polyamines such as diethylene triamine or derivatives of aminoethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R. Koslowsky, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. In case of exposure by an argon ion laser a blue sensitizing dye is incorporated. In case of exposure by a red light emitting source, e.g. a LED or a HeNe laser a red sensitizing dye is used. In case of exposure by a semiconductor laser special spectral sensitizing dyes suited for the near infra-red are required. Suitable infra-red sensitizing dyes are disclosed in i.a. US-P 2,095,854, 2,095,856, 2,955,939, 3,482,978, 3,552,974, 3,573,921, 3,582,344, 3,623,881 and 3,695,888.

A preferred blue sensitizing dye, green sensitizing dye, red sensitizing dye and infra-red sensitizing dye in connection with the present invention are described in EP-A 554,585.

To enhance the sensitivity in the red or near infra-red region use can be made of so-called supersensitizers in combination with red or infra-red sensitizing dyes. Suitable supersensitizers are described in Research Disclosure Vol 289, May 1988, item 28952. The spectral sensitizers can be added to the photographic emulsions in the form of an aqueous solution, a solution in an organic solvent or in the form of a dispersion.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds.

In accordance with the present invention gelatin is used as binder in the photosensitive silver halide emulsion layer(s). Gelatin can, however, be replaced in part by synthetic, semi-synthetic, or natural polymers. According to the invention, the silver halide emulsion layer contains gelatin whereof a 10 % by weight aqueous solution at 36 °C and pH 6 has a viscosity lower than 20 mPa.s at a shearing rate of 1000 $s^{-1}$, measured with a viscosimeter operating with a rotating cylinder and marketed under the tradename HAAKE ROTOVISCO rheometer Type M 10, wherein the cylinder can be rotated at 1000 rpm and a maximal shearing rate of 44,500 $s^{-1}$. Said low viscosity gelatin is preferably combined with a gelatin of a higher viscosity. The weight ratio of said low viscosity gelatin versus the gelatin of a higher viscosity is preferably more than 0.5.

Preferably the gelatin layer(s) is (are) substantially unhardened. Substantially unhardened means that when such gelatin layer is coated on a subbed polyethylene terephtalate film base at a dry thickness of 1.2 $g/m^2$, dried for 3 days at 57 C° and 35% R.H. and dipped in water of 30 C°, said gelatin layer is dissolved for more than95 % by weight within 5 minutes.

The silver halide emulsions may contain pH controlling ingredients. Preferably at least one gelatin containing layer is coated at a pH value not below the iso-electric point of the gelatin to avoid interactions between said gelatin containing coated layer and the hereafter mentioned intermediate layer. More preferably the gelatin layer contiguous to said intermediate layer is coated at a pH value not below the iso-electric point of the gelatin. Most preferably all the gelatin containing layers are coated at a pH value not below the iso-electric point of their gelatin. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions suitable for use in accordance with the present invention can be found in e.g. Product Licensing Index, Vol. 92, December 1971, publication 9232, p. 107-109.

Apart from negative-working silver halide emulsions that are preferred for their high light-sensitivity, use can be made also of direct-positive silver halide emulsions that produce a positive silver image.

For instance, direct-positive silver halide emulsions that mainly forms an internal image as described in e.g. EP-A 365,926 and US-P 3,062,651 may be employed. Alternatively, prefogged direct-positive silver halide emulsions with internal or, more preferably, with external electron traps as disclosed in EP-A 94201899.5 and EPA 481,562 are also suitable for use in connection with the present invention.

Preferably, the imaging element also comprises an intermediate layer between the image receiving layer on the hydrophilic base and the photosensitive layer (packet) to facilate the removal of said layer (packet) thereby uncovering the silver image formed in the image receiving layer by processing the imaging element.

In one embodiment, the intermediate layer is a water-swellable intermediate layer coated at a ratio of 0.01 to 2.0 g/m2 and comprising at least one non-proteinic hydrophilic film-forming polymer e.g. polyvinyl alcohol and optionally comprising an antihalation dye or pigment as disclosed in EP-A-410500.

In another embodiment, the intermediate layer is a layer comprising hydrophobic polymer beads having an average diameter not lower than 0.2 µm and having been prepared by polymerization of at least one ethylenically unsaturated monomer. Preferably, said intermediate layer in dry condition comprises said hydrophobic polymer beads in an amount of up to 80% of its total weight. Further details are disclosed in EP-A-483415.

A supplemental intermediate layer, which may be present between said silver halide emulsion containing layer and said water-swellable intermediate layer or said intermediate layer comprising hydrophobic polymer beads may incorporate one or more ingredients such as i.a. antihalation dyes or pigment, developing agents, silver halide solvents, base precursors, and anticorrosion substances.

When the imaging element is prepared by laminating a layer packet comprising a photosensitive layer onto the image receiving layer the intermediate layer(s) are provided on the photosensitive layer(s), the water-swellable intermediate layer or the intermediate layer comprising hydrophobic polymer beads having an average diameter not lower than 0.2 µm and having been prepared by polymerization of at least one ethylenically unsaturated monomer being the upper layer.

The following examples illustrate the present invention without however, limiting it thereto. All parts, percentages and ratios are by weight unless otherwise indicated.

EXAMPLE 1 ( Comparative example)

A 0,30 mm thick aluminium foil (AA 1050) was degreased by immersing the foil in an aqueous solution containing 10 % phosphoric acid and subsequently etched in an aqueous solution containing 2 g/l of sodium hydroxide. The foil was then electrochemically grained using an alternating current in an aqueous solution containing 4 g/l of hydrochloric acid and 4 g/l of hydroboric acid at a temperature of 35 °C to form a surface topography with an average center-line roughness Ra of 0,6 µm. The aluminium plate was then desmutted with an aqueous solution containing 30 % of sulfuric acid at 60 °C for 120 seconds. The foil was subsequently subjected to anodic oxidation in a 20 % sulfuric acid aqueous solution to form an anodic oxidation film of 3.0 g/$m^2$ of $Al_2O_3.H_2O$, treated with an aqueous solution containing 20 g/l of $NaHCO_3$ at 45 °C for 30 sec and then rinsed with demineralised water and dried.

The imaging element was obtained by coating the grained, anodized and sealed aluminium support with a silver-receptive stratum containing 1.1 mg/$m^2$ PdS as physical development nuclei.

An intermediate layer was then provided on the dry silver-receptive stratum from an aqueous composition in such a way that the resulting dried layer had a weight of 0.5 g of polymethyl methacrylate beads per $m^2$, said composition comprising:

| | |
|---|---|
| a 20 % dispersion of polymethyl methacrylate beads in a mixture of equal volumes of water and ethanol having an average diameter of 1.0 µm | 50 ml |
| Helioechtpapierrot BL (trade mark for a dye sold by BAYER AG, D-5090 Leverkusen, West-Germany) | 2.5 g |
| saponine | 2.5 g |
| sodium oleylmethyltauride | 1.25 g |
| demineralised water | 300 ml |
| (pH-value : 5.6) | |

Finally a substantially unhardened photosensitive negative-working cadmium-free gelatin silver chlorobromoiodide emulsion layer (97.98 / 2 / 0.02 mol%) containing 1 mmole/mole AgX of 4-hydroxy-6-methyl-1,3,3a,7-tetraazaindene was coated on the intermediate layer, the silver halide being provided in an amount corresponding to 2.40 g of silver nitrate per $m^2$ and the gelatin content of the emulsion layer being 1.58 g/$m^2$, consisting of 0.7 g/$m^2$ of a gelatin with a viscosity of 21 mPa.s and the remainder of a gelatin with a viscosity of 14 mPa.s

The imaging element was exposed through a contact screen in a process-camera and immersed for 10 s at 24°C in one of 5 freshly made developing solution A - E having the following common ingredients but differing in the 1,2,4-triazolium-3-thiolate used as revealed in table 2:

| | |
|---|---|
| carboxymethylcellulose | 4 g |
| sodium hydroxide | 22.5 g |
| anhydrous sodium sulphite | 120 g |
| hydroquinone | 20 g |
| 1-phenyl-3-pyrazolidinone | 6 g |
| potassium bromide | 0.75 g |
| N-(2-aminoethyl) ethanolamine | 30 ml |
| ethylene diamine tetraacetic acid tetrasodium salt | 2 g |
| demineralised water to make | 1000 ml |
| pH (24°C) = 13 | |

The initiated diffusion transfer was allowed to continue for 30 s to form a silver image in the image receiving layers.

To remove the developed silver halide emulsion layer and the intermediate layer from the aluminium foil the developed monosheet DTR materials were rinsed for 30 s with a water jet at 20°C.

Next, the imaged surface of the aluminium foil was guided for 15 s through a fixer at 20 °C to enhance the water-receptivity of the non-image areas and to make the image areas oleophilic ink-receptive. The fixer had the following composition :

| | |
|---|---|
| 10% aqueous n-hexadecyl trimethyl ammonium chloride | 25 ml |
| 20% aqueous solution of polystyrene sulphonic acid | 100 ml |
| potassium nitrate | 12.5 g |
| citric acid | 20.0 g |
| 1-phenyl-5 -mercaptotetrazole | 2.0 g |
| sodium hydroxide | 5.5 g |
| water to make | 1000 ml |
| pH (20°C) = 4 | |

The printing plates thus prepared were mounted on the same offset printing machine (ROTOMATIC R-35) and were used for printing under identical conditions. Commercial AQUA TAME 7035E, marketed by Anchor/Lithemko Inc., Florida, was used at a 5 % concentration in an aqueous solution containing 10 % isopropanol as dampening solution and K+E 123 W, marketed by Kast+Ehinger, A.G., Germany, was used as ink. A compressible rubber blanket was used.

The ink acceptance was evaluated as follows : the number of copies that has to be printed before they are free of any white spot in the ink accepting areas.

The results are given in the following Table 2.

Table 2

| Developer | Added compound | Amount(mmol/l) | Ink acceptance |
|---|---|---|---|
| A | 11 | 6.5 | >>200 |
| B | 12 | 6.5 | >>200 |
| C | table 1: Cpd 7 | 6.5 | 50 - 100 |
| D | table 1: Cpd 8 | 6.5 | 50 - 100 |
| E | table 1: Cpd 3 | 6.5 | 100 |

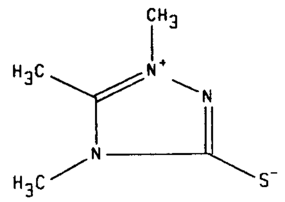

(11)

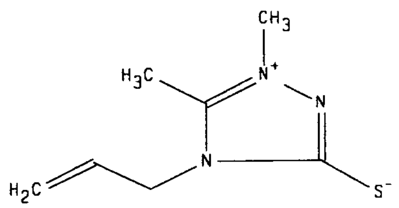

(12)

Evaluation:

From the above it can be seen that when an exposed DTR imaging element as described above is processed in a solution comprising compounds 11 or 12 (comparative 1,2,4-triazolium-3-thiolates) the ink acceptance of the obtained printing plate is so bad that even after 200 copies the copies are still completely white. By processing in a solution comprising compounds 3, 7 or 8 of table 1 (1,2,4-triazolium-3-thiolates in accordance with the invention) the ink acceptance of the obtained printing plate is very acceptable.

EXAMPLE 2

An imaging element prepared as in example 1 was exposed through a contact screen in a process-camera and immersed for 10 s at 24°C in one of the developing solution D or F, the composition of F differing from this of D by the substitution of compound 7 of table 1 (6.5 mmol/l) and N-(2-aminoethyl)-ethanolamine (30 ml/l) by anhydrous sodium thiosulphate (8 g/l).

The imaging elements and printing plates were then further processed as described in example 1. After printing 100 copies the reproduction characteristics of the two plates were evaluated by measuring the difference in line width between the printing lines, respectively the non-printing lines on the plate and on the copies. The reproduction characteristics of the plate obtained by developing the imaging element in solution D are much better than those of the plate obtained by developing the imaging element in solution E, the difference for the first plate being for the printing lines about 5 µm, for the non-printing lines about 1 to 2 µm, the difference for the second plate being for the printing lines about 7 to 8 µm, for the non-printing lines about 5µm.

## Claims

1. A method for making an offset printing plate according to the silver salt diffusion transfer process comprising the steps of:
   - image-wise exposing an imaging element comprising in the order given on a hydrophilic surface of a support (i) an image receiving layer containing physical development nuclei and (ii) a photosensitive layer containing a silver halide emulsion and gelatin whereof a 10 % by weight aqueous solution at 36 °C and pH 6 has a viscosity lower than 20 mPa.s at a shearing rate of 1000 $s^{-1}$, said photosensitive layer being in water permeable relationship with said image receiving layer,
   - applying an aqueous alkaline solution to the imaging element in the the presence of (i) (a) developing agent(s), (ii) a 1,2,4-triazolium-3-thiolate and (iii) (a) further silver halide solvent(s) to form a silver image in said image receiving layer,
   - treating the imaging element to remove the layer(s) on top of the image receiving layer, thereby uncovering said silver image formed in said image receiving layer,

   characterized in that said 1,2,4-triazolium-3-thiolate is substituted with at least one substituent selected from the group consisting of a $C_1$-$C_8$ alkyl group that comprises at least 3 fluorine atoms, a $C_4$-$C_{10}$ hydrocarbon group and a 4-amino group substituted with a $C_1$-$C_8$ alkyl group that comprises at least 3 fluorine atoms and/or a $C_4$-$C_{10}$ hydrocarbon group.

2. A method according to claim 1 wherein said 1,2,4-triazolium-3-thiolate are substituted with at least one substituent selected from the group consisting of a $C_1$-$C_5$ alkyl group that comprises at least one $CF_3$-group and/or at least two $-CF_2$-groups, a $C_4$-$C_8$ hydrocarbon group or a 4-amino group substituted with a $C_1$-$C_5$ alkyl group that comprises at least one $CF_3$-group and/or at least two $-CF_2$-groups or a $C_4$-$C_8$ hydrocarbon group and have a total number of carbon atoms less than 18.

3. A method according to claim 2 wherein said 1,2,4-triazolium-3-thiolate corresponds to one of the following two formulas I or II:

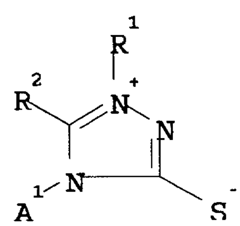

(I)

wherein $R^1$ represents a $C_1$-$C_5$ alkyl group that comprises at least one $CF_3$-group and/or at least two $-CF_2$-groups, $R^2$ represents an alkyl group, alkenyl group, alkynyl group, cycloalkyl group, aralkyl group, aryl group or heterocyclic group, $A^1$ represents an alkyl group, alkenyl group, alkynyl group, cycloalkyl group, aralkyl group, aryl group, heterocyclic group or $-NR^3R^4$ and $R^3$ and $R^4$ each independently represents hydrogen or an alkyl group or aryl group or $R^3$ and $R^4$ can combine with each other to form a 5- or 6-membered ring and wherein the total number of carbon atoms is less than 14;

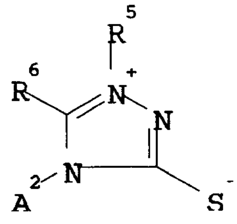

(II)

wherein $R^5$ and $R^6$ each independently represents an alkyl group, alkenyl group, alkynyl group, cycloalkyl group, aralkyl group, aryl group or heterocyclic group, $A^2$ represents an alkyl group, alkenyl

group, alkynyl group, cycloalkyl group, aralkyl group, aryl group, heterocyclic group or $-NR^7R^8$, $R^7$ and $R^8$ each independently represents hydrogen or an alkyl group or aryl group, wherein at least one of the substituents $R^5$, $R^6$, $R^7$ or $R^8$ is a $C_4$-$C_8$ hydrocarbon group and wherein the total number of carbon atoms is less than 14.

**4.** A method according to claim 3 wherein said 1,2,4-triazolium-3-thiolate corresponds either to formula I wherein $R^1$ represents a $C_1$-$C_5$ alkyl group that comprises at least one $CF_3$-group and/or at least two-$CF_2$-groups and $R^2$ and $A^1$ each independently represents an $C_1$-$C_4$ alkyl group, alkenyl group or alkynyl group; or to formula II wherein $R^5$ and $R^6$ or $R^5$ and $A^2$ or $R^6$ and $A^2$ each independently represents a $C_1$-$C_4$ alkyl group, alkenyl group or alkynyl group, the third substituent represents a $C_4$-$C_8$ alkyl group, $C_4$-$C_8$ alkenyl group, $C_4$-$C_8$ alkynyl group, $C_5$-$C_8$ cycloalkyl group and wherein the total number of carbon atoms is less than 14.

**5.** A method according to claim 3 wherein said 1,2,4-triazolium-3-thiolate corresponds to formula I wherein $R^1$ represents a $C_1$-$C_5$ alkyl group that comprises at least one $CF_3$-group and/or at least two $-CF_2$-groups and $R^2$ and $A^1$ each independently represents an methyl or ethyl group; or to formula II wherein $R^5$ and $R^6$ or $R^5$ and $A^2$ or $R^6$ and $A^2$ each independently represents a methyl or ethyl group and the third substituent represents a $C_4$-$C_8$ alkyl group, $C_4$-$C_8$ alkenyl group, $C_4$-$C_8$ alkynyl group or $C_5$-$C_8$ cycloalkyl group.

**6.** A method according to claim 3 wherein said 1,2,4-triazolium-3-thiolate corresponds to formula I wherein $R^1$ represents a $CF_3CH_2$-group and $R^2$ and $A^1$ each independently represents a methyl or ethyl group; or to formula II wherein $R^5$ and $R^6$ or $R^5$ and $A^2$ or $R^6$ and $A^2$ each independently represents a methyl or ethyl group and the third substituent represents a $C_4$-$C_8$ alkyl group or $C_4$-$C_8$ alkenyl group.

**7.** A method according to any of claims 1 to 6 wherein said further silver halide solvent is an alkanolamine or a thioether.

**8.** A method according to claim 7 wherein said alkanolamine is N-(2-aminoethyl)ethanolamine.

**9.** A method according to any of claims 1 to 8 wherein said 1,2,4-triazolium-3-thiolate is present in said alkaline processing liquid.

**10.** A method according to any of claims 1 to 8 wherein said 1,2,4-triazolium-3-thiolate is present in said imaging element.

**11.** A method according to any of claims 1 to 10 wherein said hydrophilic base is a grained and anodized aluminium support.

**12.** An imaging element comprising in the order given on a hydrophilic surface of a support (i) an image receiving layer containing physical development nuclei and (ii) a photosensitive layer containing a silver halide emulsion and gelatin whereof a 10 % by weight aqueous solution at 36 °C and pH 6 has a viscosity lower than 20 mPa.s at a shearing rate of 1000 $s^{-1}$, said photosensitive layer being in water permeable relationship with said image receiving layer, characterized in that said imaging element comprises in an amount between 0.1 and 10mmol/$m^2$ a 1,2,4-triazolium-3-thiolatesubstituted with at least one substituent selected from the group consisting of a $C_1$-$C_8$ alkyl group that comprises at least 3 fluorine atoms, a $C_4$-$C_{10}$ hydrocarbon group and a 4-amino group substituted with a $C_1$-$C_8$ alkyl group that comprises at least 3 fluorine atoms and/or a $C_4$-$C_{10}$ hydrocarbon group.

European Patent Office

# EUROPEAN SEARCH REPORT

Application Number
EP 95 20 0325

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,A | EP-A-0 554 585 (AGFA-GEVAERT NV)<br>* page 11, line 7 - line 8 *<br>* claims 1-13 *<br>--- | 1,12 | G03F7/07<br>G03C8/36<br>G03C1/047 |
| A | EP-A-0 535 678 (FUJI PHOTO FILM CO. LTD.)<br>* claims 1-4 *<br>--- | 1,12 | |
| A | US-A-4 510 228 (Y TSUBAI ET AL)<br>* column 4, line 10 - column 5, line 15; claim 2 *<br>----- | 1,12 | |
| | | | TECHNICAL FIELDS SEARCHED (Int.Cl.6) |
| | | | G03F<br>G03C |

The present search report has been drawn up for all claims

| Place of search | Date of completion of the search | Examiner |
|---|---|---|
| THE HAGUE | 14 July 1995 | Bolger, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document